# EUROPEAN PATENT SPECIFICATION

(11) **EP 3 800 277 B1**
(45) Date of publication and mention of the grant of the patent: **10.05.2023**
(21) Application number: 19201057.7
(22) Date of filing: 02.10.2019
(51) Int. Cl.: C23C 18/16, C23C 18/54, H05K 3/24

(54) **METHOD FOR PERFORMING IMMERSION TIN PROCESS IN THE PRODUCTION OF A COMPONENT CARRIER**
VERFAHREN ZUR DURCHFÜHRUNG EINES TAUCHVERZINNUNGSPROZESSES BEI DER HERSTELLUNG EINES KOMPONENTENTRÄGERS
PROCÉDÉ PERMETTANT D'EFFECTUER UN PROCESSUS D'ÉTAIN PAR IMMERSION LORS DE LA PRODUCTION D'UN SUPPORT DE COMPOSANT

(43) Date of publication of application: 07.04.2021
(73) Proprietor: AT & S Austria Technologie & Systemtechnik Aktiengesellschaft, 8700 Leoben-Hinterberg (AT)
(72) Inventor: Trischler, Heinrich, 8063 Eggersdorf bei Graz (AT)
(74) Representative: Dilg, Haeusler, Schindelmann Patentanwaltsgesellschaft mbH

(56) References cited:
- EP-A1- 2 470 686
- GB-A- 1 436 645
- US-A- 4 608 275
- US-A- 5 211 831
- US-A- 5 648 125

## Description

The invention relates to a method for performing an immersion tin process in the production of a component carrier.

In the manufacture of a component carrier, such as a printed circuit board (PCB) or a substrate, the provision of metal surfaces is a common task.

For example, tin surfaces may be provided as a final surface finish serving as a solderable or bondable surface for subsequent assembly steps. Tin is often deposited onto copper portions of a component carrier denoted as contact pads. The method of choice for tin application is deposition of tin by electroless plating procedures with immersion tin plating as the most commonly applied method. In particular, for an immersion tin surface finish in PCB production the immersion tin process may be applied. The formation of thin tin layers (down to 1 µm) on copper PCB pads is typically performed by an immersion reaction in an acidic Sn(II) thiourea solution. The copper of the PCB pads is oxidized and replaced by tin metal, which is deposited from the acidic thiourea Sn(II) solution, in accordance with the following reaction equation: 2 Cu + Sn²⁺ → 2 Cu⁺ + Sn.

Subsequently, the tin plated copper surfaces typically have to be rinsed in order to remove any copper ions from the PCB, which may disturb in subsequent processing and contaminate the PCB. To this end, three rinsing techniques are commercially available: (1) a thiourea rinsing system (thereby complexing the copper ions), (2) an alkali rinsing system with sodium hydroxide (NaOH) solution (thereby precipitating the copper ions as copper hydroxides), and (3) a high flow water rinsing system. However, a thiourea rinsing system results in the formation of toxic copper-thiourea products, which cannot be recycled, but requires expensive waste disposal. On the other hand, by using an alkali rinsing system with sodium hydroxide, it is difficult (if not practically impossible) to achieve a pH range where the solubility of copper hydroxides is minimum (typically at pH 9 - 9.5). Rather, since the acidic Sn(II) thiourea solution typically comprises the strong acid methanesulfonic acid, a reaction thereof with the strong base sodium hydroxide results in a sudden change in pH to strongly alkaline conditions, rendering it very difficult to control the pH (for instance by means of a PID pH controller) to a preferred range of minimum solubility. Moreover, copper hydroxide thus precipitated and collected in a circulation filter may re-dissolve at other pH values and contaminate the PCB with copper ions, which is highly undesired. Finally, a high flow water rinsing system requires large amounts of rinsing water, which have to be purified again. In addition, the rinsing efficiency of a high flow water rinsing system may not be sufficient so as to fulfill ever stricter requirements in PCB technology.

EP2470686 discloses a method of electroless tin plating on copper features in the manufacturing of printed circuit boards IC substrates, semiconductor wafers and the like.

Thus, there may be a need for improvements in terms of rinsing tin plated copper surfaces in the course of an immersion tin process in the production of a component carrier.

It is therefore an object of the invention to provide a method, which allows for performing an immersion tin process in the production of a component carrier in a reliable, environment-friendly and cost efficient manner.

In order to achieve the object defined above, a method for performing an immersion tin process in the production of a component carrier according to the independent claim is provided.

According to an exemplary embodiment of the invention, a method of performing an immersion tin process in the production of a component carrier (such as a printed circuit board or a substrate) is provided which comprises electroless plating of tin on at least a part of a copper surface of the component carrier by immersing said part of the copper surface (in particular a copper pad) in a composition (in particular an acidic solution) containing Sn(II), and subsequently rinsing the tin-plated part of the copper surface carrier with a rinsing composition (solution) comprising an alkali carbonate (in particular sodium carbonate).

In the context of the present application, the term "immersion tin process" may particularly denote a process of electroless plating of tin (or tin alloys) as a surface finish (in particular of copper surfaces, such as copper pads) in the manufacturing of a component carrier. It may therefore also be referred to as an "immersion tin plating process" or "electroless tin plating process".

According to an exemplary embodiment of the invention, a method for performing an immersion tin process is provided wherein a tin-plated part of a copper surface carrier of a component carrier in an immersion tin process is rinsed with a rinsing solution comprising an alkali carbonate (in particular sodium carbonate). Hereby, it may be possible to efficiently remove (in particular precipitate) copper ions from the tin-plated part of the copper surface carrier. In particular, it may be possible to adjust and maintain the pH value within a range of from 8.5 to 10, in particular from 9.0 to 9.5, where the solubility of copper hydroxides is minimum. In addition to copper hydroxides, the copper ions may be precipitated as copper carbonate, which is almost insoluble in neutral and alkaline pH conditions, so that re-dissolving of copper precipitates in the circulations filters (used for removing the copper precipitates, such as copper hydroxides and copper carbonate) and contamination of the PCB with copper ions can be significantly reduced, if not completely avoided. Moreover, the removed (such as filtered) copper precipitates may be recycled so that the copper may be recovered. As a result, an immersion tin process in the production of a component carrier may be carried out in a reliable, environment-friendly and cost efficient manner.

In the following, further exemplary embodiments of the method for performing an immersion tin process will be explained. However, the present invention is not limited to the following specific descriptions of exemplary embodiments, but they are rather for illustrative purposes only.

It should be noted that features described in connection with one exemplary embodiment or exemplary aspect may be combined with any other exemplary embodiment or exemplary aspect, in particular features described with any exemplary embodiment of a method of performing an immersion tin process may be combined with any other exemplary embodiment of a method of performing an immersion tin process and vice versa, unless specifically stated otherwise.

Where an indefinite or definite article is used when referring to a singular term, such as "a", "an" or "the", a plural of that term is also included and vice versa, unless specifically stated otherwise, whereas the word "one" or the number "1", as used herein, typically means "just one" or "exactly one".

It should be noted that the term "comprising" does not exclude other elements or steps and, as used herein, includes not only the meaning of "comprising", "including" or "containing", but also encompasses "consisting essentially of" and "consisting of".

Unless specifically stated otherwise, the expressions "at least partially", "at least a partial" or "at least a part of", as used herein, may mean at least 5 % thereof, in particular at least 10 % thereof, in particular at least 15 % thereof, in particular at least 20 % thereof, in particular at least 25 % thereof, in particular at least 30 % thereof, in particular at least 35 % thereof, in particular at least 40 % thereof, in particular at least 45 % thereof, in particular at least 50 % thereof, in particular at least 55 % thereof, in particular at least 60 % thereof, in particular at least 65 % thereof, in particular at least 70 % thereof, in particular at least 75 % thereof, in particular at least 80 % thereof, in particular at least 85 % thereof, in particular at least 90 % thereof, in particular at least 95 % thereof, in particular at least 98 % thereof, and may also mean 100 % thereof.

In an embodiment, the method of performing an immersion tin process in the production of a component carrier comprises:
- immersing at least a part of a copper surface (in particular a copper pad) of the component carrier in an (acidic) composition (in particular a solution) containing Sn(II),
- subsequently rinsing the (tin-plated) part of the copper surface carrier with a rinsing composition (in particular a solution) comprising an alkali carbonate (in particular sodium carbonate).

In an embodiment, the step of immersing at least a part of a copper surface of the component carrier in a composition (in particular a solution) containing Sn(II) comprises a dipping of the at least a part of a copper surface of the component carrier in a bath containing a Sn(II)-containing solution. Additionally or alternatively, the composition containing Sn(II) may be sprayed or otherwise applied onto the at least a part of a copper surface of the component carrier.

In an embodiment, the composition containing Sn(II) further contains a complexing agent for copper (in particular for copper ions) and an acid. By taking this measure, the yield and/or the speed of the copper/tin redox reaction may be increased. The complexing agent for copper may in particular comprise thiourea and/or the acid may in particular comprise methanesulfonic acid, which have proven particularly suitable for an immersion tin process.

In an embodiment, the immersing step is carried out at a temperature of from 50 to 95 °C, in particular 60 to 85 °C, in particular 70 to 75 °C, which have proven particularly suitable temperatures for carrying out an immersion tin process.

In an embodiment, the rinsing step is carried out at a temperature of from 20 to 40 °C, in particular 20 to 30 °C. Thus, while not excluded, it is typically not required to carry out the rinsing step at an elevated temperature, thereby saving heating costs.

In an embodiment, the rinsing step is carried out for a period (rinsing time) of from 2 seconds to 2 minutes, in particular 4 seconds to 1 minute, in particular 10 seconds to 30 seconds. Thus, while not excluded, it is typically not required to carry out the rinsing step for a long period of time, thereby further improving process efficiency.

In an embodiment, the rinsing composition is a solution, in particular an aqueous solution, i.e. containing water as a solvent.

In an embodiment, the rinsing composition is configured for adjusting (such as controlling and/or maintaining) a pH value (of a mixture of the applied rinsing composition and the Sn(II)-containing composition adhering at the tin-plated part of the copper surface) in a range of from 8.5 to 10, in particular of from 9.0 to 9.5. When rinsing the tin-plated part of the copper surface with a rinsing composition comprising an alkali carbonate, the pH value is increased by the alkaline rinsing composition so that copper hydroxides (CuOH and/or Cu(OH)₂) as well as copper carbonate (CuCO₃) may precipitate. By adjusting the pH value of a mixture of the applied rinsing composition and the Sn(II)-containing composition adhering at the tin-plated part of the copper surface by means of the rinsing composition within a range of from 8.5 to 10, in particular of from 9.0 to 9.5, the solubility of the copper hydroxides can be lowered to its minimum and copper carbonate is also almost insoluble within this pH range so that copper ions may be substantially completely (quantitatively) precipitated and thus removed.

In an embodiment, the rinsing composition comprises 50 to 100 g/l alkali carbonate, in particular 70 to 90 g/l alkali carbonate, such as about 80 g/l alkali carbonate. These concentrations have proven to be particularly efficient for precipitating and removing copper ions. In particular, by taking this measure, a pH value (of a mixture of the applied rinsing composition and the Sn(II)-containing composition adhering at the tin-plated part of the copper surface) may be adjusted (such as controlled and/or maintained) within a range of from 8.5 to 10, in particular of from 9.0 to 9.5.

In an embodiment, the alkali carbonate may comprise at least one of sodium carbonate and/or potassium carbonate. Among them, sodium carbonate (Na₂CO₃) is particularly suitable for solving the object of the present invention, because it is not only very efficient at adjusting the pH value within a range of from 8.5 to 10, in particular of from 9.0 to 9.5, and at precipitating copper ions as copper hydroxides and copper carbonate, but it is furthermore a very inexpensive chemical, in particular less expensive than sodium hydroxide conventionally used in an alkali rinsing system of an immersion tin process.

In an embodiment, the rinsing composition further comprises sodium hydroxide (NaOH) or another alkali hydroxide, such as potassium hydroxide (KOH), in addition to the alkali carbonate. By taking this measure, it may be possible to neutralize the typically acidic composition containing Sn(II) to a large extent by means of sodium hydroxide, and to adjust or fine-tune the pH by means of the alkali carbonate, thereby also buffering the pH value of the composition. As a result, the total amount of alkali carbonate required for adjusting the pH value may be lowered or, in other words, a part of the alkali carbonate may be replaced or substituted by sodium hydroxide or another alkali hydroxide, which may be advantageous for cost reasons.

In an embodiment, the method further comprises removing a precipitate (such as copper hydroxides and/or copper carbonate, e.g. Cu(OH)₂, CuCO₃) formed in the rinsing step from the rinsing composition.

In an embodiment, the step of removing a precipitate includes filtration which has proven not only a very efficient measure for substantially completely removing the precipitate from the rinsing composition, but also allows for recycling the precipitate so as to recover copper.

In an embodiment, the method may further comprise recovering copper from the removed precipitate (such as copper hydroxides and/or copper carbonate, e.g. Cu(OH)₂, CuCO₃). For instance, copper carbonate may be decomposed by heating into copper oxides (CuzO, CuO) and carbon dioxide or may be dissolved by an acid so as to release copper from the copper carbonate precipitate and recover copper therefrom.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene.

In an embodiment, the at least one electrically insulating layer structure comprises at least one of the group consisting of resin (such as reinforced or non-reinforced resins, for instance epoxy resin or Bismaleimide-Triazine resin), cyanate ester, polyphenylene derivate, glass (in particular glass fibers, multilayer glass, glass-like materials), prepreg material (such as FR-4 or FR-5), polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg particularly FR4 are usually preferred for rigid PCBs, other materials in particular epoxy-based build-up film or photoimageable dielectric material for substrates may be used as well. For high frequency applications, high-frequency materials such as polytetrafluoroethylene, liquid crystal polymer and/or cyanate ester resins, low temperature cofired ceramics (LTCC) or other low, very low or ultra-low DK-materials may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are OSP (Organic Solderability Preservative), Electroless Nickel Immersion Gold (ENIG), gold (in particular Hard Gold), chemical tin, nickel-gold, nickel-palladium, etc.

The aspects defined above and further aspects of the invention are apparent from the exemplary embodiments to be described hereinafter and are explained with reference to these exemplary embodiments.
Figure 1 illustrates the change in pH when providing a solution containing a strong acid with a strong base (A) and with a weak base (B), such as an alkali carbonate according to an exemplary embodiment of the invention.
Figure 2 illustrates the solubility of copper hydroxide as a function of the pH and the pH control of a copper-containing solution by means of sodium hydroxide rinsing and by means of sodium carbonate rinsing according to an exemplary embodiment of the invention.

The illustrations in the drawings are schematical.

Before referring to the drawings, some basic considerations will be summarized based on which exemplary embodiments of the invention have been developed.

Standard immersion tin (Imm Tin) lines typically have 3 rinse systems:
1) Thiourea rinse to complex the copper ions
2) Alkali rinse with sodium hydroxide solution pH 6 - 11
3) High flow water rinse

To eliminate any copper ions from the PCB during rinse process the copper and tin ions are precipitated as copper hydroxide or tin hydroxide solid. Copper hydroxide has the lowest solubility in the pH range between 9 and 9.5. Therefore, the pH range from 9 to 9.5 is the desired operating window for any alkali rinse, because in this pH range the largest amount of copper will be precipitated as copper hydroxide (100 times more precipitate formed) and can be efficiently removed from the PCB.

Further, by the formation of copper hydroxide solids, formed at pH 9 to 9.5, the largest amount of copper ions is eliminated from the circulating cleaning water and collected in the circulation filters.

The conventional alkaline rinse has a major drawback in that a strong acid, methanesulfonic acid (MSA), is reacted with a strong base, sodium hydroxide.

Reacting a strong acid with a strong base will always cause a big change on pH scale resulting in a difficult or even impossible controlling via PID pH controller.

A pH jump between 6.5 and 11.8 is observed in the sodium hydroxide alkali rinse. This big change of pH with strong acid reacting with strong alkali is a basic knowledge of pH controlling and titration chemistry.

However, a decrease of the pH from pH 9 to pH 7 or an increase of the pH from pH 9 to pH 11 will cause a re-solubility of copper hydroxide formed at pH 9.

The re-solubility of copper hydroxide is highly undesired, because larger amounts of copper hydroxide solids can be collected in the circulation filters of the alkali rinse, and when re-dissolved at the wrong pH the PCB will be flushed with water that contains a large amount of undesired copper ions.

To solve the problem of controlling the pH, keeping it constant between 9 and 10, and to make a high precipitation rate of copper hydroxide and/or copper carbonate possible, surprisingly the weak base sodium carbonate has been found to be successful according to an exemplary embodiment of the invention.

At pH 7, copper hydroxide is slightly soluble whereas copper carbonate is insoluble. Therefore carbonate solutions are more efficient to remove copper ions as copper carbonate precipitates over a larger range of pH as well.

Small amounts of carbonate ions from sodium carbonate are working as copper complex formation reagent forming copper carbonate precipitate.

Therefore, the function of carbonate ions besides the adjustment of pH in the soda rinse is equal to the thiourea as a copper complexing reagent.

Maybe because of the risk of formation of large amounts of insoluble copper carbonate forming from copper ions and carbonate ions in the alkaline rinse, it has hitherto never been thought about using sodium carbonate as an alkali source for the alkali rinse in immersion tin lines. However, the weak base sodium carbonate decomposes to sodium hydroxide and carbon dioxide, during the reaction with acid MSA, which has been maybe not considered by the experts so far. As side reaction a small amount of carbon dioxide bubbles is formed during the reaction of sodium carbonate with the strong acid MSA.

Below is given a comparison of the chemical reactions between the two rinses:
A) Conventional alkali rinse with strong sodium hydroxide:
   Reaction of sodium hydroxide with MSA results into the sodium salt of MSA:

      NaOH + CH₃-SO₃H → CH₃-SO₃⁻Na⁺ + H₂O
   Copper ions react with sodium hydroxide to desired insoluble copper hydroxide:

      Cu²⁺ + 2 NaOH → Cu(OH)₂ + 2 Na⁺
B) Soda rinse according to an exemplary embodiment of the invention:
   Reaction of sodium carbonate with MSA acid protons to sodium hydroxide and carbon dioxide:

      Na₂CO₃ + H⁺ → Na⁺ + OH- + CO₂ + H₂O
   Reaction of sodium hydroxide with MSA results into the sodium salt of MSA:

      NaOH + CH₃-SO₃H → CH₃-SO₃⁻Na⁺ + H₂O
   Reaction of sodium carbonate with MSA results into the sodium salt of MSA and carbon dioxide:

      Na₂CO₃ + CH₃-SO₃H → CH₃-SO₃⁻Na⁺ + CO₂ + H₂O
   Copper ions react with sodium hydroxide to desired insoluble copper hydroxide:

      Cu²⁺ + 2 NaOH → Cu(OH)₂ + 2 Na⁺
   Copper ions react with sodium carbonate to desired insoluble copper carbonate:

      Cu²⁺ + 2 NaCO₃ → CuCO₃ + 2 Na⁺

To react the strong acid MSA in the immersion tin solution with the strong alkali NaOH will always cause a big change on pH scale between pH 6 and pH 12. This big change in pH will result in a difficult or even impossible controlling via PID pH controller. This is a well-known chemical phenomenon.

To solve the problem of controlling the pH and keeping it constant between 9 and 9.5 the reaction of weak base sodium carbonate with the strong acid MSA has been found to be successful according to an exemplary embodiment of the invention. The fact that a weak base with a strong acid result in a lower pH in the alkaline regime is well known. Nevertheless, sodium carbonate has hitherto not been considered as a suitable alkali source. However, when reacting with acid, sodium carbonate is partly decomposed into carbon dioxide and sodium hydroxide. Sodium hydroxide will react with copper ions to form the desired copper hydroxide precipitate. Further carbonate will form with copper ions copper carbonate precipitate.

In a nutshell, according to an exemplary embodiment of the invention, the pH of immersion tin alkali rinse may be controlled between 9 - 9.5 by using sodium carbonate as a weak base - and not via tuned PID controller, two dosing pumps with two pH controllers or other engineering devices which are shown to be not successful in controlling the pH of a strong acid and alkali. Controlling the pH between pH 9 - 9.5 is easier and robust between strong acid and weak base. Simple dosing pump in combination with a pH controller can be used with constant feeding for the soda solution.

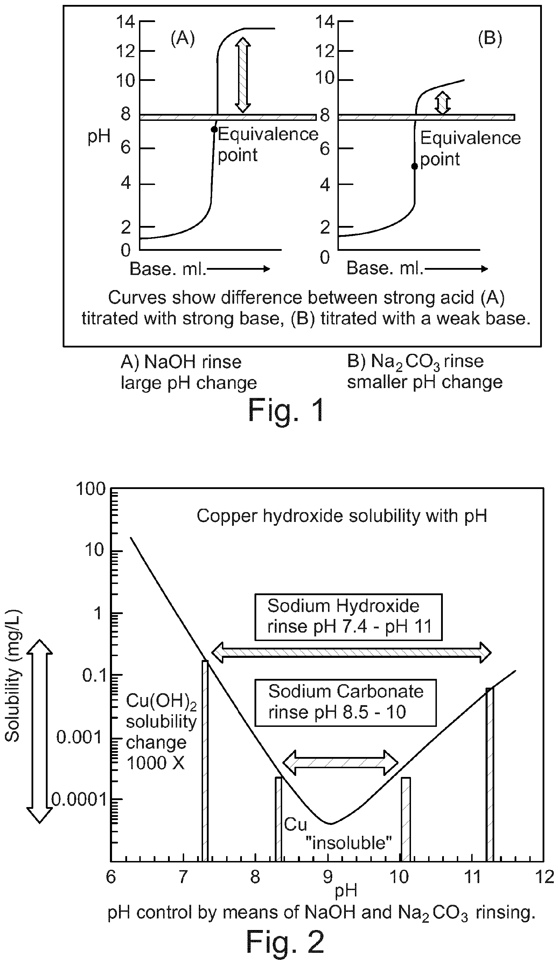

**Figure 1** illustrates the change in pH when providing a solution containing a strong acid with a strong base (A) and with a weak base (B), such as an alkali carbonate according to an exemplary embodiment of the invention. As evident from the left-hand part (A) of Figure 1, when titrating a solution containing a strong acid (such as methanesulfonic acid) with a strong base (such as sodium hydroxide), a sudden change from a low pH value of less than about pH 3 to a high pH value of more than about pH 12 occurs. However, a desired pH range where for the solubility of copper hydroxides is minimum (such as at pH 9 - 9.5) is very difficult (if not impossible) to achieve. In contrast, as evident from the right-hand part (B) of Figure 1, when titrating a solution containing a strong acid (such as methanesulfonic acid) with a weak base (such as sodium carbonate), the pH value also rises, but to a smaller extent, in particular not to a high pH value of more than about pH 12. Rather, the obtained solution is buffered in a moderate alkaline pH range. As a result, a desired pH range where for the solubility of copper hydroxides is minimum (such as at pH 9 - 9.5) may be easily adjusted and maintained.

**Figure 2** illustrates the solubility of copper hydroxide as a function of the pH and the pH control of a copper-containing solution by means of sodium hydroxide rinsing and by means of sodium carbonate rinsing according to an exemplary embodiment of the invention. As evident from Figure 2, the solubility of copper hydroxide strongly depends on the pH value with a minimum in solubility at pH 9 - 9.5, whereas the solubility of copper hydroxide increases with higher and lower pH values. Moreover, it is shown in Figure 2 that by means of sodium carbonate rinsing according to an exemplary embodiment of the invention, the pH value can be appropriately adjusted within a pH range of from 8.5 to 10 safeguarding a low solubility of copper hydroxide, whereas by means of conventional sodium hydroxide rinsing, the pH varies between 7.4 and 11 posing a strong risk of insufficient precipitation of copper ions and undesired re-dissolution of copper hydroxide.

### EXAMPLES

The invention is further described by the following examples, which are solely for the purpose of illustrating specific embodiments, and are not construed as limiting the scope of the invention in any way.

### Concentration of Copper in the alkali rinse cascade bath:

0.1 l/m² Imm Tin chemistry in the bath containing 6.8 g/l copper ions
   → Copper content 0.68 g/m²
   → 1 m² or 3 panels are produced in 3 minutes
   40 liters cascade bath volume
900 liters/h or 15 liters per minute water inlet
   -+ Every 3 minutes the complete cascade bath volume is replaced with new water
   → 0.68 g/m² copper can give at 100 % conversion maximum 2.2 g copper carbonate

However, the copper carbonate decomposes into sodium hydroxide and carbon dioxide and every 3 minutes all the water in the cascade is replaced with new water. A very small amount of copper carbonate is expected to be formed and collected into the circulation filters of the rinse.

### Quality of 20 PCBs after trial at pH 9.7 - 10.2:

Appearance after soda rinse: OK
4 hours at 150 °C in aging oven: all cards OK

### Quality tests results of soda rinse PCBs cards:

Aging tests 40 cards from 4 trials: 3 hours at 155 °C - All cards OK
Reflow tests 10 cards from 2 trials: 2 times reflow at 240 °C - All cards OK
Wave soldering wetting test 10 cards from 2 trials: - All cards OK

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of performing an immersion tin process in the production of a component carrier, wherein the method comprises:
electroless plating of tin on at least a part of a copper surface of the component carrier by immersing said part of the copper surface in a composition containing Sn(II),
subsequently rinsing the tin-plated part of the copper surface carrier with a rinsing composition, **characterised in that** the rinsing composition comprises an alkali carbonate.

2. The method of performing an immersion tin process in the production of a component carrier according to claim 1, wherein the composition containing Sn(II) further contains a complexing agent for copper and an acid.

3. The method of performing an immersion tin process in the production of a component carrier according to claim 2, wherein the complexing agent for copper comprises thiourea and/or wherein the acid comprises methanesulfonic acid.

4. The method of performing an immersion tin process in the production of a component carrier according to any of the preceding claims, wherein the immersing step is carried out at a temperature of from 50 to 95 °C, in particular 60 to 85 °C, in particular 70 to 75 °C.

5. The method of performing an immersion tin process in the production of a component carrier according to any of the preceding claims, wherein the rinsing step is carried out at a temperature of from 20 to 40 °C, in particular 20 to 30 °C.

6. The method of performing an immersion tin process in the production of a component carrier according to any of the preceding claims, wherein the rinsing step is carried out for a period of from 2 seconds to 2 minutes, in particular 4 seconds to 1 minute, in particular 10 seconds to 30 seconds.

7. The method of performing an immersion tin process in the production of a component carrier according to any of the preceding claims, wherein the rinsing composition is configured for adjusting a pH value in a range of from 8.5 to 10, in particular of from 9.0 to 9.5.

8. The method of performing an immersion tin process in the production of a component carrier according to any of the preceding claims, wherein the rinsing composition comprises 50 to 100 g/l alkali carbonate, in particular 70 to 90 g/l alkali carbonate.

9. The method of performing an immersion tin process in the production of a component carrier according to any of the preceding claims, wherein the alkali carbonate is selected from the group consisting of sodium carbonate and potassium carbonate.

10. The method of performing an immersion tin process in the production of a component carrier according to any of the preceding claims, wherein the alkali carbonate comprises sodium carbonate.

11. The method of performing an immersion tin process in the production of a component carrier according to any of the preceding claims, wherein the rinsing composition further comprises sodium hydroxide.

12. The method of performing an immersion tin process in the production of a component carrier according to any of the preceding claims, further comprising:
subsequently removing a precipitate formed in the rinsing step from the rinsing composition.

13. The method of performing an immersion tin process in the production of a component carrier according to claim 12, wherein the step of removing a precipitate includes filtration.

14. The method of performing an immersion tin process in the production of a component carrier according to claim 12 or 13, further comprising:
recovering copper from the removed precipitate.

## Patentansprüche

1. Ein Verfahren zum Ausführen eines Immersionszinnprozesses bei der Produktion eines Komponententrägers, wobei das Verfahren aufweist:
stromloses Beschichten von Zinn auf zumindest einen Teil einer Kupferoberfläche des Komponententrägers mittels Eintauchens des Teils der Kupferoberfläche in eine Zusammensetzung, welche Sn(II) enthält,
nachfolgendes Spülen des zinnbeschichteten Teils des Kupferoberflächenträgers mit einer Spülzusammensetzung,
**dadurch gekennzeichnet, dass** die Spülzusammensetzung ein Alkalicarbonat aufweist.

2. Das Verfahren zum Ausführen eines Immersionszinnprozesses bei der Produktion eines Komponententrägers gemäß Anspruch 1, wobei die Zusammensetzung, welche Sn(II) enthält, ferner ein komplexbildendes Mittel für Kupfer und eine Säure enthält.

3. Das Verfahren zum Ausführen eines Immersionszinnprozesses bei der Produktion eines Komponententrägers gemäß Anspruch 2, wobei das komplexbildende Mittel für Kupfer Thioharnstoff aufweist und/oder wobei die Säure Methansulfonsäure aufweist.

4. Das Verfahren zum Ausführen eines Immersionszinnprozesses bei der Produktion eines Komponententrägers gemäß einem beliebigen der vorangehenden Ansprüche, wobei der Eintauchen-Schritt bei einer Temperatur von 50 bis 95 °C durchgeführt wird, insbesondere 60 bis 85 °C, insbesondere 70 bis 75 °C.

5. Das Verfahren zum Ausführen eines Immersionszinnprozesses bei der Produktion eines Komponententrägers gemäß einem beliebigen der vorangehenden Ansprüche, wobei der Spülen-Schritt bei einer Temperatur von 20 bis 40 °C durchgeführt wird, insbesondere 20 bis 30 °C.

6. Das Verfahren zum Ausführen eines Immersionszinnprozesses bei der Produktion eines Komponententrägers gemäß einem beliebigen der vorangehenden Ansprüche, wobei der Spülen-Schritt für eine Dauer von 2 Sekunden bis 2 Minuten durchgeführt wird, insbesondere 4 Sekunden bis 1 Minute, insbesondere 10 Sekunden bis 30 Sekunden.

7. Das Verfahren zum Ausführen eines Immersionszinnprozesses bei der Produktion eines Komponententrägers gemäß einem beliebigen der vorangehenden Ansprüche, wobei die Spülzusammensetzung zum Einstellen eines pH-Werts in einem Bereich von 8,5 bis 10 konfiguriert ist, insbesondere von 9,0 bis 9,5.

8. Das Verfahren zum Ausführen eines Immersionszinnprozesses bei der Produktion eines Komponententrägers gemäß einem beliebigen der vorangehenden Ansprüche, wobei die Spülzusammensetzung 50 bis 100 g/l Alkalicarbonat aufweist, insbesondere 70 bis 90 g/Liter Alkalicarbonat.

9. Das Verfahren zum Ausführen eines Immersionszinnprozesses bei der Produktion eines Komponententrägers gemäß einem beliebigen der vorangehenden Ansprüche, wobei das Alkalicarbonat aus der Gruppe ausgewählt ist, bestehend aus Natriumcarbonat und Kaliumcarbonat.

10. Das Verfahren zum Ausführen eines Immersionszinnprozesses bei der Produktion eines Komponententrägers gemäß einem beliebigen der vorangehenden Ansprüche, wobei das Alkalicarbonat Natriumcarbonat aufweist.

11. Das Verfahren zum Ausführen eines Immersionszinnprozesses bei der Produktion eines Komponententrägers gemäß einem beliebigen der vorangehenden Ansprüche, wobei die Spülzusammensetzung ferner Natriumhydroxid aufweist.

12. Das Verfahren zum Ausführen eines Immersionszinnprozesses bei der Produktion eines Komponententrägers gemäß einem beliebigen der vorangehenden Ansprüche, ferner aufweisend:
nachfolgendes Entfernen eines Präzipitats, welches bei dem Spülen-Schritt aus der Spülzusammensetzung gebildet wird.

13. Das Verfahren zum Ausführen eines Immersionszinnprozesses bei der Produktion eines Komponententrägers gemäß Anspruch 12, wobei der Schritt des Entfernens eines Präzipitats eine Filtration enthält.

14. Das Verfahren zum Ausführen eines Immersionszinnprozesses bei der Produktion eines Komponententrägers gemäß Anspruch 12 oder 13, ferner aufweisend:
Gewinnen von Kupfer aus dem entfernten Präzipitat.

## Revendications

1. Procédé permettant de réaliser un processus d'étain par immersion dans la production d'un support de composant, dans lequel le procédé comprend :
le dépôt autocatalytique d'étain sur au moins une partie d'une surface de cuivre du support de composant par immersion de ladite partie de la surface de cuivre dans une composition contenant du Sn(II),
le rinçage ultérieur de la partie étamée du support à surface de cuivre avec une composition de rinçage, **caractérisé en ce que** la composition de rinçage comprend un carbonate alcalin.

2. Procédé permettant de réaliser un processus d'étain par immersion dans la production d'un support de composant selon la revendication 1, dans lequel la composition contenant du Sn(II) contient en outre un agent complexant pour le cuivre et un acide.

3. Procédé permettant de réaliser un processus d'étain par immersion dans la production d'un support de composant selon la revendication 2, dans lequel l'agent complexant pour le cuivre comprend de la thiourée et/ou dans lequel l'acide comprend de l'acide méthanesulfonique.

4. Procédé permettant de réaliser un processus d'étain par immersion dans la production d'un support de composant selon l'une quelconque des revendications précédentes, dans lequel l'étape d'immersion est réalisée à une température de 50 à 95 °C, en particulier 60 à 85 °C, en particulier 70 à 75 °C.

5. Procédé permettant de réaliser un processus d'étain par immersion dans la production d'un support de composant selon l'une quelconque des revendications précédentes, dans lequel l'étape de rinçage est réalisée à une température de 20 à 40 °C, en particulier 20 à 30 °C.

6. Procédé permettant de réaliser un processus d'étain par immersion dans la production d'un support de composant selon l'une quelconque des revendications précédentes, dans lequel l'étape de rinçage est réalisée pendant une période de 2 secondes à 2 minutes, en particulier 4 secondes à 1 minute, en particulier 10 secondes à 30 secondes.

7. Procédé permettant de réaliser un processus d'étain par immersion dans la production d'un support de composant selon l'une quelconque des revendications précédentes, dans lequel la composition de rinçage est configurée pour ajuster une valeur de pH dans une plage de 8,5 à 10, en particulier de 9,0 à 9,5.

8. Procédé permettant de réaliser un processus d'étain par immersion dans la production d'un support de composant selon l'une quelconque des revendications précédentes, dans lequel la composition de rinçage comprend 50 à 100 g/l de carbonate alcalin, en particulier 70 à 90 g/l de carbonate alcalin.

9. Procédé permettant de réaliser un processus d'étain par immersion dans la production d'un support de composant selon l'une quelconque des revendications précédentes, dans lequel le carbonate alcalin est choisi dans le groupe constitué du carbonate de sodium et du carbonate de potassium.

10. Procédé permettant de réaliser un processus d'étain par immersion dans la production d'un support de composant selon l'une quelconque des revendications précédentes, dans lequel le carbonate alcalin comprend du carbonate de sodium.

11. Procédé permettant de réaliser un processus d'étain par immersion dans la production d'un support de composant selon l'une quelconque des revendications précédentes, dans lequel la composition de rinçage comprend en outre de l'hydroxyde de sodium.

12. Procédé permettant de réaliser un processus d'étain par immersion dans la production d'un support de composant selon l'une quelconque des revendications précédentes, comprenant en outre :
le retrait ultérieur d'un précipité formé dans l'étape de rinçage à partir de la composition de rinçage.

13. Procédé permettant de réaliser un processus d'étain par immersion dans la production d'un support de composant selon la revendication 12, dans lequel l'étape de retrait d'un précipité comporte une filtration.

14. Procédé permettant de réaliser un processus d'étain par immersion dans la production d'un support de composant selon la revendication 12 ou 13, comprenant en outre :
la récupération de cuivre à partir du précipité retiré.
